(19) Europäisches Patentamt
European Patent Office
Office européen des brevets

(11) **EP 4 270 034 A1**

(12) **EUROPEAN PATENT APPLICATION**

(43) Date of publication:
**01.11.2023 Bulletin 2023/44**

(21) Application number: **22170550.2**

(22) Date of filing: **28.04.2022**

(51) International Patent Classification (IPC):
**G01R 31/64** (2020.01)

(52) Cooperative Patent Classification (CPC):
**G01R 31/64; G01R 31/006**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **VOLVO TRUCK CORPORATION**
**405 08 Göteborg (SE)**

(72) Inventors:
• **MESHACH DANIEL, P**
**600040 Chennai (IN)**
• **B, Ranjith Kumar**
**560043 Bangalore (IN)**

(74) Representative: **Zacco Sweden AB**
**P.O. Box 5581**
**Löjtnantsgatan 21**
**114 85 Stockholm (SE)**

(54) **A MEASUREMENT TOOL AND A METHOD FOR DETERMINING A STATE OF HEALTH (SOH) OF A CAPACITOR COMPONENT IN A VEHICLE**

(57) The disclosure relates to a method performed by a measurement tool for determining a State of Health, SOH, of a capacitor component in a vehicle, wherein the method comprises performing charging and discharging of the capacitor component according to a specific determined charge and discharge cycle; obtaining current and voltage measurements during both the charging and discharging of the capacitor component; determining an Equivalent Series Resistance, ESR, and a capacitance of the capacitor component based on the obtained current and voltage measurements; and determining the SOH of the capacitor component based on the determined capacitance and ESR. The disclosure further relates to a measurement tool for determining a SOH of a capacitor component, a computer program product, a computer program carrier carrying a computer program product and a vehicle.

FIG. 4

EP 4 270 034 A1

**Description**

TECHNICAL FIELD

Embodiments herein relate in general to capacitor components. In particular, embodiments herein relate to a measurement tool and a method performed by a measurement tool for determining a State of Health, SOH, of a capacitor component in a vehicle. Further, the embodiments herein also relate to a computer program product for performing the method and a computer program product carrier.

BACKGROUND

Some capacitor components, such as, for example, super-capacitors or ultra-capacitors, SC/UCs, has for the last couple of years opened up for several different and interesting applications, such as, e.g. regenerative braking, short-term energy storage, or burst-mode power delivery, within transportation. A normal application area is within different types of vehicles and transports, such as, automobiles, buses, trains, cranes and elevators, etc. These type of SC/UC capacitors, for example, have advantages in applications where a large amount of power is needed for a relatively short time and where a very high number of charge/discharge cycles or a longer lifetime is required. Typical applications range from mA currents or mW of power for up to a few minutes to several Amperes current or several hundred kW power for much shorter periods.

More specifically, SC/UC capacitors are high-capacity capacitors with capacitance values that are much higher than other conventional capacitors, but with lower voltage limits. This allows the gap between electrolytic capacitors and rechargeable batteries to be bridged. SC/UC capacitors are typically capable of storing about 10 to 100 times more energy per unit volume or mass than electrolytic capacitors. Normally, the SC/UC capacitors may also accept and deliver charge much faster than batteries, and tolerate many more charge and discharge cycles than rechargeable batteries. Contrary to regular capacitors, the SC/UC capacitors do not use a solid dielectric, but rather use, for example, electrostatic double-layer capacitance or electrochemical pseudo-capacitance, etc. The SC/UC capacitors are also DC only, and is not applicable to AC.

However, as for conventional capacitors, there is a need to be able to evaluate and monitor the SOH of SC/UC capacitors, in particular in vehicle applications. For example, a SC/UC capacitor may be used in a cranking application for an internal combustion engine of a truck. In this case, if the SC/US capacitor has reached its End-of-Life, EoL, before being replaced, then this may result in that the engine will be unable to start and that the truck will be left standing.

SUMMARY

It is an object of embodiments herein to provide a measurement tool and a method performed by a measurement tool, along with a computer program product and carrier, for determining a State of Health, SOH, of a capacitor component in a vehicle that seeks to mitigate, alleviate, or eliminate all or at least some of the above-discussed drawbacks of presently known solutions.

According to a first aspect of embodiments herein, the object is achieved by a method performed by a measurement tool for determining a SOH of a capacitor component in a vehicle. The method comprise performing charging and discharging of the capacitor component according to a specific determined charge and discharge cycle. The method also comprises obtaining current and voltage measurements during both the charging and discharging of the capacitor component. The method further comprises determining an Equivalent Series Resistance, ESR, and a capacitance of the capacitor component based on the obtained current and voltage measurements. Further, the method comprises determining the SOH of the capacitor component based on the determined capacitance and ESR.

By obtaining the current and voltages measurements during both the charging and discharging of the capacitor component and use these measurements in order to calculate the ESR and capacitance of the capacitor component to obtain its SOH, it is possible to quickly and efficiently predict the SOH of a capacitor component in a vehicle accurately. Hence, it provides a feasible way for a maintenance or service team to easily monitor and evaluate the current SOH of the capacitor component in a vehicle, e.g. for pre-emptive maintenance and inventory purposes.

In some embodiments, the charging and discharging is performed further based on the ambient temperature surrounding the capacitor component. Since the ambient temperature surrounding capacitor component will affect its ability to store voltage, this means that the ambient temperature is used to optimize the charging and discharge cycles of the capacitor component, i.e. to adjust the charging and discharge voltages. In some embodiments, the ambient temperature is used to determine suitable charging voltage, VC. This means that the charging and discharge voltages may be adjusted to in order to maintain the proper charging voltage for a specific ambient temperature.

In some embodiments, the specific determined charge and discharge cycle is less than 120 seconds long. This advantageously allows for suitably long settling times for the charging and discharging of the capacitor component, while still providing for a time-efficient maintenance or service procedure. Here, for example, a suitable time for the charge and discharge cycle may depend on the configuration of the capacitor component, but longer than 120 seconds will most likely make the maintenance operation less effective and more time-consuming than needed.

In some embodiments, the method further comprises providing, to a user of the measurement tool via a display, information indicating the SOH of the capacitor component. This means that a maintenance or service operator may be provided with an indication of the SOH in an easy and efficient manner. In some embodiments, the method further comprises determining a time period until the capacitor component is in need of being replaced based on the determined SOH of the capacitor component. In this case, according to some embodiments, the method also comprise providing, to a user of the measurement tool via the display, information indicating the determined time period. This means that a maintenance or service operator may be provided with an expected time until the capacitor component is in need of being replaced. In some embodiments, the capacitor component is a super- or ultra-capacitor.

According to a second aspect of embodiments herein, the object is achieved by a measurement tool for determining a SOH of a capacitor component in a vehicle. The measurement tool is configured to perform charging and discharging of the capacitor component according to a specific determined charge and discharge cycle, obtain current and voltage measurements during both the charging and discharging of the capacitor component, determine an Equivalent Series Resistance, ESR, and a capacitance of the capacitor component based on the obtained current and voltage measurements, and determine the SOH of the capacitor component based on the determined capacitance and ESR.

According to a third aspect of the embodiments herein, the object is achieved by a computer program product comprising instructions which, when executed in a processing circuitry, cause the processing circuitry to carry out the method according to the first aspect described above. According to a fourth aspect of the embodiments herein, the object is achieved by a carrier containing any of the computer program products described above, wherein the carrier is one of an electronic signal, optical signal, radio signal, or computer-readable storage medium. According to a fifth aspect of the embodiments herein, there is provided a vehicle comprising a measurement tool according to any of the second aspect.

Effects and features of the second through fifth aspects are to a large extent analogous to those described above in connection with the first aspect. Embodiments mentioned in relation to the first aspect are largely compatible with the second through fifth aspects. The present disclosure will become apparent from the detailed description given below. The detailed description and specific examples disclose preferred embodiments of the disclosure by way of illustration only. Those skilled in the art understand from guidance in the detailed description that changes and modifications may be made within the scope of the disclosure.

Hence, it is to be understood that the herein disclosed disclosure is not limited to the particular component parts of the device described or steps of the methods described since such device and method may vary. It is also to be understood that the terminology used herein is for purpose of describing particular embodiments only, and is not intended to be limiting. It should be noted that, as used in the specification and the appended claim, the articles "a", "an", "the", and "said" are intended to mean that there are one or more of the elements unless the context explicitly dictates otherwise. Thus, for example, reference to "a unit" or "the unit" may include several devices, and the like. Furthermore, the words "comprising", "including", "containing" and similar wordings does not exclude other elements or steps.

BRIEF DESCRIPTION OF THE DRAWINGS

Features and advantages of the embodiments will become readily apparent to those skilled in the art by the following detailed description of exemplary embodiments thereof with reference to the accompanying drawings, wherein:

Fig. 1    is a side view of a vehicle,
Fig. 2    is schematic block diagram illustrating a vehicle and embodiments of measurement tool,
Fig. 3    is a flowchart illustrating a method according to some embodiments,
Fig. 4    is a diagram illustrating discharging and charging cycles according to some embodiments, and
Fig. 5    is diagram illustrating a relationship between a capacitor component's ESR and capacitance versus its SOH according to some embodiments, and
Fig. 6    is diagram illustrating a relationship between temperatures and charging voltage according to some embodiments.

DETAILED DESCRIPTION

The figures are schematic and simplified for clarity, and they merely show details which are essential to the understanding of the embodiments presented herein, while other details have been left out. Throughout, the same reference numerals are used for identical or corresponding parts or steps.

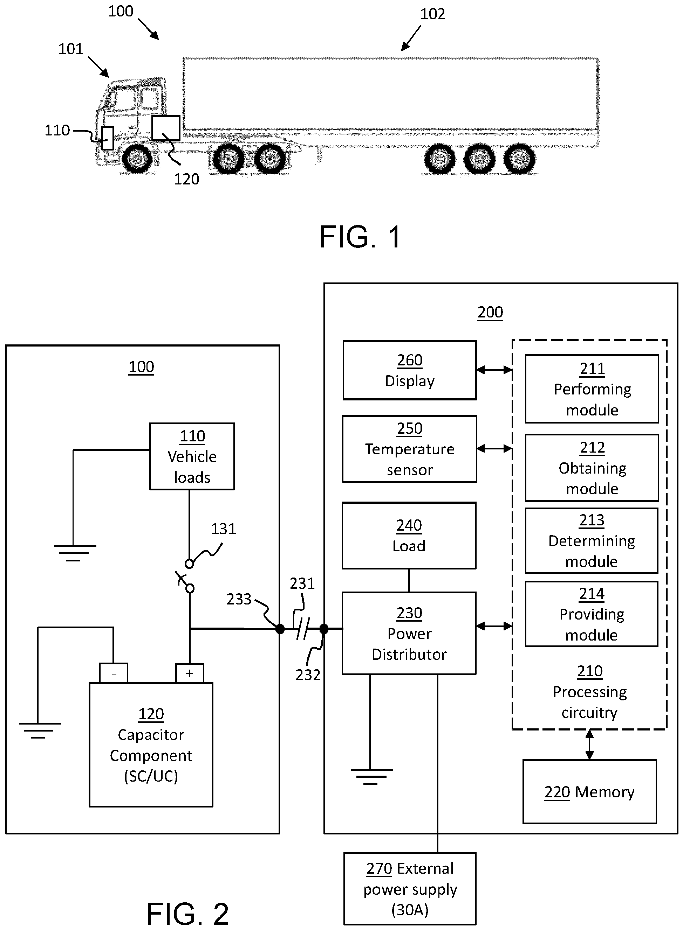

**Fig. 1** illustrates an example of a **vehicle 100.** In this case, the vehicle 100 is exemplified as a heavy-duty vehicle combination for cargo transport. The vehicle 100 in Fig. 1 comprises a **truck or towing vehicle 101** configured to tow a **trailer unit 102** in a known manner, e.g., by a fifth wheel connection. Herein, a heavy-duty vehicle is taken to be a vehicle designed for the handling and transport of heavier objects or large quantities of cargo. As an example, a heavy-duty vehicle could be a semi-trailer vehicle, or a truck as described above. As another example, a heavy-duty vehicle could be a vehicle designed for use in construction, mining operations, and the like. It is appreciated that the techniques and devices disclosed herein can be applied together with a wide variety of electrically powered vehicle units, not just those exemplified in Fig. 1. Thus, the techniques disclosed herein are also applicable to, e.g., rigid trucks and also multi-trailer electric heavy-duty vehicles comprising one or more dolly vehicle units. Thus, even though the embodiments herein are described mainly with respect to heavy-duty vehicles, such as, e.g. semi-trailer vehicles or trucks for cargo transport, the embodiments herein should not be considered restricted to this particular type of vehicle but may also be used in other types of vehicles.

The vehicle 100 also comprise a **capacitor component 120.** The capacitor component 120 may be a super-capacitor or ultra-capacitor, SC/UC. Here, it should bed noted that an UC/SC is a capacitor component that stores energy in form of an electrostatic field. It is a polar type capacitor that has a high energy density, such as, e.g. between 1-19Whr/Kg. Ordinary capacitor components normally has dielectric materials in between its anode and cathode which limits it's range to less than one (1) Farad. UCs/SCs on the other hand normally has an electrolytic solution and thin insulating material (also referred to as a separator) between its anode and cathode which helps to store high capacitance range, such as, e.g. one (1) Farad up to 10,000 Farad.

Further, the capacitor component 120 may be arranged to provide power to **one or more onboard vehicle loads 110.** The onboard vehicle loads 110 may, for example, be a cranking application for an internal combustion engine of the vehicle 100. Another example may be support as backup power for fuel cell-operated vehicles or battery-operated vehicles, wherein the capacitor component may supply the power when the primary source of energy is depleted or not functioning. Further examples of onboard vehicle loads 110 may include regenerative braking arrangements or on-board arrangements adapted to provide a quick burst of acceleration over short distances, or to start the main engine of the vehicle 100.

**Fig.** 2 illustrates schematic block diagram of the vehicle 100 and a **measurement tool 200** according to some embodiments. Here, to the left in Fig. 2 is the vehicle side, i.e. the vehicle 100 comprising the capacitor component 120 and the one or more onboard vehicle loads 110. The vehicle 100 may further comprise a **switch 131.** Optionally, the switch 131 may be controlled internally by the vehicle 100 (e.g. the switch 131 may be opened by entering a maintenance or service mode) and/or externally by the measurement tool 200 (e.g. the switch 131 may be opened when the measurement tool 200 is connected to the vehicle 100 and the capacitor component 120). The latter may be performed mechanically, electrically or based on communication between the measurement tool 200 and the vehicle 100.

On the contrary, to the right in Fig. 2 is the measurement tool side, i.e. the measurement tool 200 being connected to an external **power supply 270,** e.g. a 30A DC power source. Optionally, the measurement tool 100 may, for some applications, be provided with an internal power supply, such e.g. a built-in battery or power source. The measurement tool 100 comprises a **power distributor 230.** The power distributor 230 is arranged to be electrically connected to the onboard capacitor component 120 when the measurement tool 200 is connected to the vehicle 100. In some embodiments, the measurement tool 200 may comprise a **cable 231** having a **first end connector 232** being fixed or detachably coupled to the measurement tool 200 and the power distributor 230, and **second end connector 233** being detachably to the vehicle 100 and the capacitor component 120. According to some embodiments, the cable 231 may be a conventional electric cable, or an electric cable further arranged to provide a communication interface between the measurement tool 200 and the vehicle 100, e.g. to control the switch 131. Also, the power distributor 230 is connected to the external power supply 270, as well as, a **load 240.** The load 240 may be used by the power distributor 230 to discharge the capacitor component 120 of the vehicle 100, while the external power supply 270 may be used by the power distributor 230 to discharge the capacitor component 120 of the vehicle 100.

The measurement tool 200 also comprise a **processing circuitry 210** and a **memory 220.** The processing circuitry 210 and the memory 220 may also be referred to as a Master Control Unit, MCU. The processing circuitry 210 may be configured to communicate with and control the power distributor 230, e.g. in order to control the discharging and charging of the capacitor component 120 of the vehicle 100. The processing circuitry 210 may also be configured to communicate with a **temperature sensor 250,** e.g. in order to receive the ambient temperature surrounding the capacitor component 120. Further, the processing circuitry 200 may be configured to communicate with and control a **display 260,** e.g. in order to display information to an operator of the measurement tool 200.

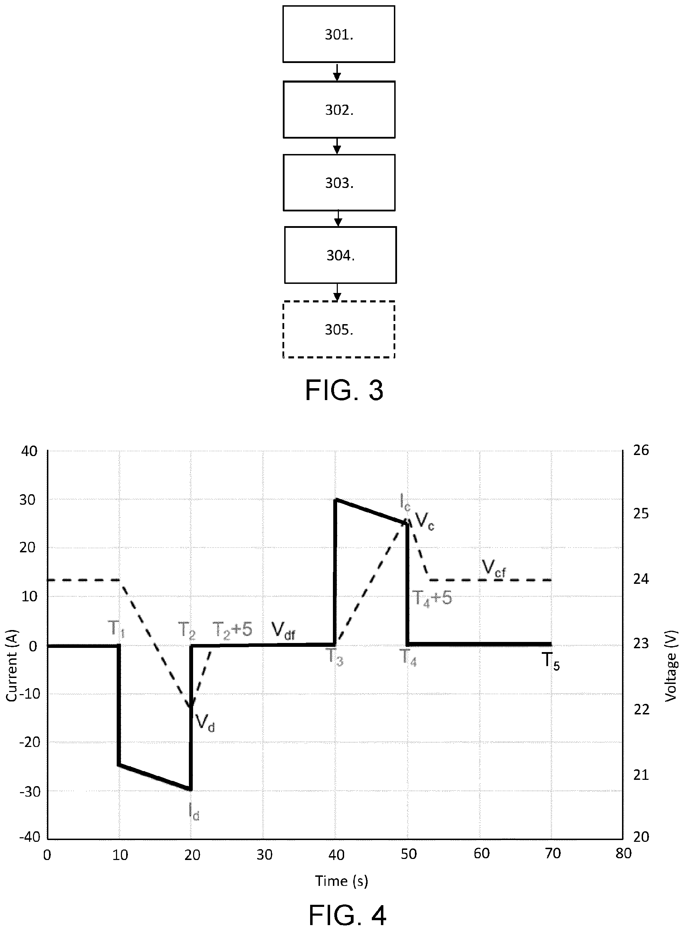

Furthermore, the processing circuitry 210 may be configured to perform the method actions for determining a State of Health, SOH, of the capacitor component 120 in the vehicle 100 described in more detail below with reference to Fig. 3. It should be noted that some or all of the functionality described in the embodiments of the method below as being performed by the measurement tool 200 may be provided by the processing circuitry 210 executing instructions stored on a computer-readable medium, such as, the memory 220 shown in Fig. 2. Alternative embodiments of the processing circuitry 210 and/or measurement tool 200 may comprise additional components, such as, for example, a **performing module 211,** an **obtaining module 212,** a **determining module 213,** and a **providing module 514,** each responsible for providing its functionality to support the embodiments described herein.

The measurement tool 200 or processing circuitry 210 is configured to, or may comprise the performing module 211 configured to, perform charging and discharging of the capacitor component 120 according to a specific determined charge and discharge cycle. Also, measurement tool 200 or processing circuitry 210 is configured to, or may comprise the obtaining module 212 configured to, obtain current and voltage measurements during both the charging and discharging of the capacitor component 120. Further, the measurement tool 200 or processing circuitry 210 is configured to, or may comprise the determining module 213 configured to, determine an Equivalent Series Resistance, ESR, and a capacitance of the capacitor component 120 based on the obtained current and voltage measurements. Furthermore, the measurement tool 200 or processing circuitry 210 is configured to, or may comprise the determining module 213 configured to, determine the SOH of the capacitor component 120 based on the determined capacitance and ESR.

In some embodiments, the measurement tool 200 or processing circuitry 210 may configured to, or may comprise the performing module 211 configured to, perform the charging and discharging based on the ambient temperature surrounding the capacitor component 120. In this case, according to some embodiments, the measurement tool 200 or processing circuitry 210 may be configured to, or may comprise the determining module 213 configured to, determine a suitable charging voltage, Vc, using the ambient temperature. In some embodiments, the specific determined charge and discharge cycle may be less than 120 seconds long.

In some embodiments, the measurement tool 200 or processing circuitry 210 may configured to, or may comprise the providing module 214 configured to, provide, to a user of the measurement tool 200 via a display 260, information indicating the SOH of the capacitor component 120. In some embodiments, the measurement tool 200 or processing circuitry 210 may be configured to, or may comprise the determining module 213 configured to, determine a time period until the capacitor component 120 is in need of being replaced based on the determined SOH of the capacitor component 120. In this case, according to some embodiments, the measurement tool 200 or processing circuitry 210 may be configured to, or may comprise the providing module 214 configured to, provide, to a user of the measurement tool 200 via the display 260, information indicating the determined time period. In some embodiments, the capacitor component 120 is a super- or ultra-capacitor.

Furthermore, the embodiments for determining a State of Health, SOH, of a capacitor component 120 in a vehicle 100 described above may be at least partly implemented through one or more processors, such as, the processing circuitry 210 in the measurement tool 200 depicted in Fig. 2, together with computer program code for performing the functions and actions of the embodiments herein. The program code mentioned above may also be provided as a computer program product, for instance in the form of a data carrier carrying computer program code or code means for performing the embodiments herein when being loaded into the processing circuitry 210 in the measurement tool 200. The data carrier, or computer readable medium, may be one of an electronic signal, optical signal, radio signal or computer-readable storage medium. The computer program code may e.g. be provided as pure program code in the measurement tool 200 or on a server and downloaded to the measurement tool 200. Thus, it should be noted that the measurement tool 200 may in some embodiments be implemented as computer programs stored in memory 220 in Fig. 2, e.g. the computer readable storage unit/module, for execution by processors or processing modules, e.g. the processing circuitry 210 in the measurement tool 200 in Fig. 2. By way of example, such computer readable medium or machine-readable media can comprise RAM, ROM, EPROM, EEPROM, CD-ROM or other optical disk storage, magnetic disk storage or other magnetic storage devices, or any other medium which can be used to carry or store desired program code in the form of machine-executable instructions or data structures and which can be accessed by a general purpose or special purpose computer or other machine with a processor. When information is transferred or provided over a network or another communications connection (either hardwired, wireless, or a combination of hardwired or wireless) to a machine, the machine properly views the connection as a machine-readable or computer readable medium. Thus, any such connection is properly termed a machine-readable or computer readable medium. Combinations of the above are also included within the scope of machine-readable or computer readable media. Machine or computer executable instructions may comprise, for example, instructions and data that cause a general-purpose computer, special purpose computer, or special purpose processing machines to perform a certain function or group of functions.

Those skilled in the art will also appreciate that the processing circuitry 210 and the memory 220 described above may refer to a combination of analog and digital circuits, and/or one or more processors configured with software and/or firmware, e.g. stored in a computer readable storage unit/module, that when executed by the one or more processors such as the processing circuitry 210 perform as described above. One or more of these processors, as well as the other digital hardware, may be included in a single application-specific integrated circuit (ASIC), or several processors and various digital hardware may be distributed among several separate components, whether individually packaged or assembled into a system-on-a-chip (SoC).

For reference, it should also be noted that the measurement tool 200 may, for example, be manifested as a general-purpose processor, an application specific processor, a circuit containing processing components, a group of distributed processing components, a group of distributed computers configured for processing, a field programmable gate array (FPGA), etc. The processor may be or include any number of hardware components for conducting data or signal processing or for executing computer code stored in memory. The memory may be one or more devices for storing data and/or computer code for completing or facilitating the various methods described in the present description. The memory may include volatile memory or non-volatile memory. The memory may include database components, object code components, script components, or any other type of information structure for supporting the various activities of the present description. According to an exemplary embodiment, any distributed or local memory device may be utilized with the systems and methods of this description. According to an exemplary embodiment the memory is communicably connected to the processor (e.g., via a circuit or any other wired, wireless, or network connection) and includes computer code for executing one or more processes described herein.

Examples of embodiments of a method performed by a measurement tool 200 for determining a State of Health, SOH, of a capacitor component 120 in a vehicle 100, will now be described with reference to the flowchart depicted in Fig. 3. Fig. 3 is an illustrated example of actions, steps or operations which may be performed by the measurement tool 200 described above with reference to Fig. 2. The method may comprise the following actions, steps or operations.

**Action 301.** The measurement tool 200 performs charging and discharging of the capacitor component 120 according to a specific determined charge and discharge cycle. This means, for example, that the measurement tool 200 may, after being connected to the vehicle 100 and the switch 131 has opened, control the power distributor 230 to discharge the capacitor component 120 using the load 240 in the measurement tool 200 according to a certain discharging cycle, such as, the discharging cycle shown and described below with reference to **Fig. 4.** After the discharging has settled and is stable, the measurement tool 200 may control the power distributor 230 to charge the capacitor component 120 using the external power supply 270 according to a certain charging cycle, such as, the charging cycle shown and described below with reference to Fig. 4. In some embodiments, the specific determined charge and discharge cycle is less than 120 seconds long. This means, for example, that the specific determined charge and discharge cycle is not allowed to be too long in order for the measurement tool 200 to be a time-efficient maintenance and service tool.

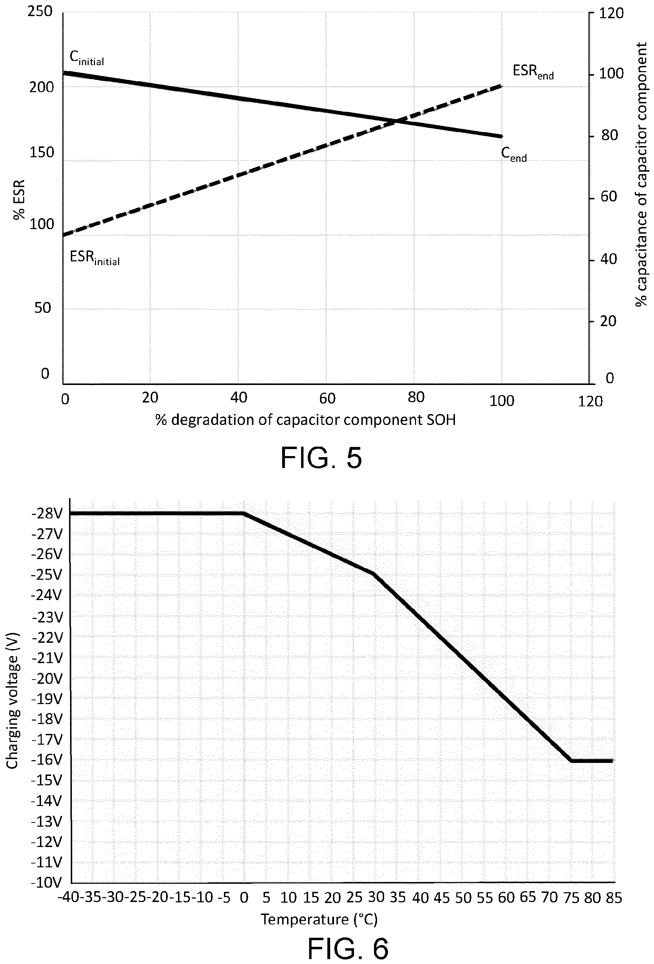

**Fig. 4** shows one example of charge and discharge cycle of the capacitor component 120 that may be performed by the measurement tool 200. In Fig. 4, the left y-axis indicates the current to/from the capacitor component 120, while the right y-axis indicated the voltage over the capacitor component 120. The x-axis in Fig. 5 shows the lapsed time. The measurement tool 200 may start by discharging the capacitor component 120 over the load 240 at time $T_1$. By time $T_2$, the voltage over the capacitor component 120 will drop down to a discharge voltage level, $V_d$, as the current is drawn from the capacitor component 120 until a discharge current level, $I_d$, is reached and the measurement tool 200 stops the discharging. Here, a suitable settling time, such as, e.g. until T3, may be adhered to in order to allow the voltage time, e.g. T2 + 5 seconds, to settle and stabilize at $V_{df}$ i.e. at 22 V. This completes the discharging cycle of the capacitor component 120. Then, the measurement tool 200 may continue start the charge cycle by initiating a re-charge of the capacitor component 120, e.g. using the external power supply 270, at time $T_3$. By time $T_4$, the voltage over the capacitor component 120 will increase to a charging voltage level, $V_c$, as the current is drawn by the capacitor component 120 until a charge current level, $I_c$, is reached and the measurement tool 200 may stop the re-charging. Also, in this case, a suitable settling time, such as, e.g. until $T_5$, may be adhered to in order to allow the voltage over the capacitor component 120 time to settle, e.g. $T_4$ + 5 seconds, and stabilize at $V_{cf}$ e.g. at 24 V or other suitable charging voltage. This completes the charging cycle of the capacitor component 120. Here, it should be noted that the main discharge time period T1 to T2 and main charging time period T3 to T4 will remain the same throughout the life of the capacitor component.

In some embodiments, the measurement tool 200 may perform the charging and discharging of the capacitor component 120 is further based on the ambient temperature surrounding the capacitor component 120. This means, for example, that since the ambient temperature surrounding capacitor component 120 will affect its ability to store voltage, the ambient temperature may be used to adjust the charging voltage and improve the charging and discharge cycles of the capacitor component 120. The ambient temperature may, for example, be provided by the temperature sensor 250 as shown in the example of Fig. 2. Here, according to some embodiments, the ambient temperature may be used to determine suitable charging voltage, Vc. This means, for example, that depending on the ambient temperature, there may be an optimal, or at least close-to-optimal, charging voltage level, $V_c$, to be used. One example of a relationship between ambient temperatures and suitable charging voltage level, $V_c$, for a capacitor component is shown in Fig. 6. **Fig. 6** shows an example of how a suitable charging voltage level, $V_c$, for the capacitor component 120 may vary depending on the ambient temperature surrounding the capacitor component 120.

Hence, the measurement tool 200 may comprise information indicating the relationship between the capacitor component 120 and the ambient temperature surrounding the capacitor component 120. This relationship may be different for different capacitor components 120.

**Action 302.** During the specific determined charge and discharge cycle in Action 301, the measurement tool 200 obtains current and voltage measurements during both the charging and discharging of the capacitor component 120. This means, for example, that a dual set of current and voltage measurements are collected by the measurement tool 200.

**Action 303.** After the measurements in Action 302, the measurement tool 200 determines an Equivalent Series Resistance, ESR, and a capacitance, C, of the capacitor component 120 based on the obtained current and voltage measurements. This means that by obtaining a dual set of current and voltage measurements are collected by the measurement tool 200, a more accurate calculation of the ESR and the capacitance of the capacitor component 120 may be obtained.

For example, based on the charging and discharging cycle shown and described below with reference to Fig. 4, the ESR of the capacitor component 120 may be calculated by determining a first resistance, $R_d$, based on the discharging cycle according to Eq. 1:

$$R_d = \left| \frac{V_d - V_{df}}{I_d} \right|$$ (Eq. 1)

and determining a second resistance, $R_c$, based on the charging cycle according to Eq. 2:

$$R_c = \left| \frac{V_c - V_{cf}}{I_c} \right|$$ (Eq. 2)

and subsequently determine the ESR of the capacitor component 120 according to Eq. 3:

$$ESR = \frac{R_c + R_d}{2}$$ (Eq. 3)

In similar manner, based on the charging and discharging cycle shown and described below with reference to Fig. 4, the capacitance, C, of the capacitor component 120 may be calculated by determining a first capacitance, $C_d$, based on the discharging cycle according to Eq. 4:

$$Cd = \left| \frac{Q_d}{V(t_2+5)-V(t_1)} \right| = \left| \frac{\int_{t1}^{t2} i(t)dt}{V_{df}-V_{cf}} \right|$$ (Eq. 4)

and determining a second capacitance, $C_c$, based on the charging cycle according to Eq. 5:

$$Cc = \left| \frac{Q_c}{V(t_4+5)-V(t_3)} \right| = \left| \frac{\int_{t3}^{t4} i(t)dt}{V_{cf}-V_{df}} \right|$$ (Eq. 5)

and subsequently determine the capacitance, C, of the capacitor component 120 according to Eq. 3:

$$C = \frac{C_c + C_d}{2}$$ (Eq. 5)

**Action 304.** As the ESR and capacitance of the capacitor component 120 is determined in Action 303, the measurement tool 200 determines the SOH of the capacitor component 120 based on the determined capacitance and ESR. This means, for example, that the measurement tool 200 may calculate the %-degradation of the capacitor component 120 based on the average values of the C and ESR separately, whereby the measurement tool 200 may be subtracted from 100% and the output will be given as the SOH of the capacitor component 120, e.g. SOH = 100 - (%-degradation based on C + %-degradation based on ESR) / 2. In other words, the degradation of the performance of the capacitor component 120, i.e. the SOH of the capacitor component 120, may be evaluated by the measurement tool 200.

**Fig. 5** shows an example of the SOH of the capacitor component 120 in relation to the degradation of ESR and capacitance of the capacitor component 120 over time and usage. The degradation of the ESR and capacitance of the capacitor component 120 are shown percentages with regards to its initial ESR and capacitance values, $ESR_{initial}$ and $C_{initial}$; both naturally starting at 100% capacity. In Fig. 5, the left y-axis indicates the percentage of the initial ESR, while the right y-axis indicated the percentage of the initial capacitance. The x-axis in Fig. 5 shows the degradation of the SOH of the capacitor component 120. Over time as the capacitor component 120 is used, the performance of the capacitor component will start to degrade. This means that the ESR will increase and the capacitance decrease of time. As exemplified in Fig. 5, when the SOH of the capacitor component 120 may be considered to come to an end when either the ESR of the capacitor component 120 has reached about two times its initial value, i.e. $ESR_{end} = 2 \times ESR_{initial}$, or when the capacitance of the capacitor component 120 has reached about 80% of its initial value, i.e. $C_{end} = 0.8 \times C_{initial}$. Hence, the measurement tool 200 may accurately determine how far the capacitor component 120 has degraded, i.e. the SOH of the capacitor component 120, by the determining the ESR and capacitance of the capacitor component 120 as described in Action 303.

**Action 305.** Optionally, after the determination of the SOH in Action 304, the measurement tool 200 may provide, to a user of the measurement tool 200 via a display 260, information indicating the SOH of the capacitor component 120. This means, for example, that the measurement tool 200 may control the display 260 to show the current degradation of the capacitor component 120 in terms of the accurately determined SOH of the capacitor component 120, e.g. in terms of the percent of degradation of SOH as shown in Fig. 5.

According to some embodiments, the measurement tool 200 may determine a time period until the capacitor component 120 is in need of being replaced based on the determined SOH of the capacitor component 120. In this case, in some embodiments, the measurement tool 200 may provide, to a user of the measurement tool 200 via the display 260, information indicating the determined time period. This means, for example, that the measurement tool 200 may be configured to determine, e.g. based on selected or predetermined settings, at which point in time the capacitor component 120 should be replaced.

The description of the example embodiments provided herein have been presented for purposes of illustration. The description is not intended to be exhaustive or to limit example embodiments to the precise form disclosed, and modifications and variations are possible in light of the above teachings or may be acquired from practice of various alternatives to the provided embodiments. The examples discussed herein were chosen and described in order to explain the principles and the nature of various example embodiments and its practical application to enable one skilled in the art to utilize the example embodiments in various manners and with various modifications as are suited to the particular use contemplated. The features of the embodiments described herein may be combined in all possible combinations of methods, apparatuses, modules, systems, and computer program products. It should be appreciated that the example embodiments presented herein may be practiced in any combination with each other.

It should be noted that the word "comprising" does not necessarily exclude the presence of other elements or steps than those listed and the words "a" or "an" preceding an element do not exclude the presence of a plurality of such elements. It should further be noted that any reference signs do not limit the scope of the claims, that the example embodiments may be implemented at least in part by means of both hardware and software, and that several "means", "units" or "devices" may be represented by the same item of hardware.

It should also be noted that the various example embodiments described herein are described in the general context of method steps or processes, which may be implemented in one aspect by a computer program product, embodied in a computer-readable medium, including computer-executable instructions, such as program code, executed by computers in networked environments. A computer-readable medium may include removable and non-removable storage devices including, but not limited to, Read Only Memory (ROM), Random Access Memory (RAM), compact discs (CDs), digital versatile discs (DVD), etc. Generally, program modules may include routines, programs, objects, components, data structures, etc. that perform particular tasks or implement particular abstract data types. Computer-executable instructions, associated data structures, and program modules represent examples of program code for executing steps of the methods disclosed herein. The particular sequence of such executable instructions or associated data structures represents examples of corresponding acts for implementing the functions described in such steps or processes. The embodiments herein are not limited to the above described preferred embodiments. Various alternatives, modifications and equivalents may be used. Therefore, the above embodiments should not be construed as limiting.

**Claims**

1. A method performed by a measurement tool (200) for determining a State of Health, SOH, of a capacitor component (120) in a vehicle (100), wherein the method comprises

   *performing* (301) charging and discharging of the capacitor component (120) according to a specific determined charge and discharge cycle;
   *obtaining* (302) current and voltage measurements during both the charging and discharging of the capacitor component (120);
   *determining* (303) an Equivalent Series Resistance, ESR, and a capacitance of the capacitor component (120) based on the obtained current and voltage measurements; and
   *determining* (304) the SOH of the capacitor component (120) based on the determined capacitance and ESR.

2. The method according to claim 1, wherein the *performing* (201) is further based on the ambient temperature surrounding the capacitor component (120).

3. The method according to claim 2, wherein the ambient temperature is used to determine suitable charging voltage, Vc.

4. The method according to any of claims 1-3, wherein the specific determined charge and discharge cycle is less than 120 seconds long.

5. The method according to any of claims 1-4, further comprising *providing* (305), to a user of the measurement tool (200) via a display (260), information indicating the SOH of the capacitor component (120).

6. The method according to any of claims 1-5, wherein the *determining* (304) further comprises determining a time period until the capacitor component (120) is in need of being replaced based on the determined SOH of the capacitor component (120), and the *providing* (305) further comprises providing, to a user of the measurement tool (200) via the display (260), information indicating the determined time period.

7. A measurement tool (200) for determining a State of Health, SOH, of a capacitor component (120) in a vehicle (100), wherein the measurement tool (200) is configured to
   perform charging and discharging of the capacitor component (120) according to a specific determined charge and discharge cycle, obtain current and voltage measurements during both the charging and discharging of the capacitor component (120), determine an Equivalent Series Resistance, ESR, and a capacitance of the capacitor component (120) based on the obtained current and voltage measurements, and determine the SOH of the capacitor component (120) based on the determined capacitance and ESR.

8. The measurement tool (200) according to claim 7, further configured to perform the charging and discharging based on the ambient temperature surrounding the capacitor component (120).

9. The measurement tool (200) according to claim 8, wherein the ambient temperature is used to determine suitable charging voltage, Vc.

10. The measurement tool (200) according to any of claims 7-9, wherein the specific determined charge and discharge cycle is less than 120 seconds long.

11. The measurement tool (200) according to any of claims 7-10, further configured to provide, to a user of the measurement tool (200) via a display (260), information indicating the SOH of the capacitor component (120).

12. The measurement tool (200) according to any of claims 7-11, further configured to determine a time period until the capacitor component (120) is in need of being replaced based on the determined SOH of the capacitor component (120), and provide, to a user of the measurement tool (200) via the display (260), information indicating the determined time period.

13. The measurement tool (200) according to any of claims 7-12, wherein the capacitor component (120) is a super- or ultra-capacitor.

14. A computer program product comprising program code means for performing the steps of any of claims 1-6, when said computer program is run on a processing circuitry (510) of a measurement tool (200).

15. A computer program carrier carrying a computer program product according to claim 14, wherein the computer program carrier is one of an electronic signal, optical signal, radio signal, or computer-readable storage medium.

FIG. 1

FIG. 2

FIG. 3

FIG. 4

FIG. 5

FIG. 6

Europäisches Patentamt

European Patent Office

Office européen des brevets

# EUROPEAN SEARCH REPORT

**Application Number**

EP 22 17 0550

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/112493 A1 (ABDENNADHER KARIM [FR] ET AL) 30 April 2009 (2009-04-30) * figures 1, 2, 5 * | 1,4-7, 10-15 | INV. G01R31/64 |
| X | US 2009/072839 A1 (KIM MYUNG CHUL [KR] ET AL) 19 March 2009 (2009-03-19) * figures 1, 2, 4-6, 8 * | 1,5,7, 11,14,15 | |
| X | WO 2019/127184 A1 (ABB SCHWEIZ AG [CH]; GE JUNJIE [CN] ET AL.) 4 July 2019 (2019-07-04) * figures 1-5, 10 * | 1,7,14, 15 | |
| X | WO 2019/127185 A1 (ABB SCHWEIZ AG [CH]; GE JUNJIE [CN] ET AL.) 4 July 2019 (2019-07-04) * figures 1-5, 8, 13 * | 1,7,14, 15 | |
| X | KRECZANIK PAUL ET AL: "Study of Supercapacitor Aging and Lifetime Estimation According to Voltage, Temperature, and RMS Current", IEEE TRANSACTIONS ON INDUSTRIAL ELECTRONICS, IEEE SERVICE CENTER, PISCATAWAY, NJ, USA, vol. 61, no. 9, 1 September 2014 (2014-09-01), pages 4895-4902, XP011543643, ISSN: 0278-0046, DOI: 10.1109/TIE.2013.2293695 [retrieved on 2014-03-21] * figures 2, 3, 6-10 * | 1,6,7, 12-15 | |

**TECHNICAL FIELDS SEARCHED (IPC)**

G01R

-/--

The present search report has been drawn up for all claims

| Place of search | Date of completion of the search | Examiner |
|---|---|---|
| Munich | 19 October 2022 | Agerbaek, Thomas |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

page 1 of 3

Europäisches
Patentamt

European
Patent Office

Office européen
des brevets

## EUROPEAN SEARCH REPORT

Application Number

EP 22 17 0550

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NASSIM RIZOUG ET AL: "Study of the Ageing Process of a Supercapacitor Module Using Direct Method of Characterization", IEEE TRANSACTIONS ON ENERGY CONVERSION, IEEE SERVICE CENTER, PISCATAWAY, NJ, US, vol. 27, no. 2, 1 June 2012 (2012-06-01), pages 220-228, XP011444443, ISSN: 0885-8969, DOI: 10.1109/TEC.2012.2186814 * figures 10-14 * | 1,6,7, 12-15 | |
| X | EL MEJDOUBI ASMAE ET AL: "Remaining Useful Life Prognosis of Supercapacitors Under Temperature and Voltage Aging Conditions", IEEE TRANSACTIONS ON INDUSTRIAL ELECTRONICS, IEEE SERVICE CENTER, PISCATAWAY, NJ, USA, vol. 65, no. 5, 1 May 2018 (2018-05-01), pages 4357-4367, XP011676074, ISSN: 0278-0046, DOI: 10.1109/TIE.2017.2767550 [retrieved on 2018-01-16] * Section III.A; figures 4, 5 * | 1,6,7, 12-15 | |
| X | BERNARDINIS ALEXANDRE DE ET AL: "Supercapacitors Aging Study: Models Theoretical Analysis and Attempt to Physical Correlation related to Applied Cycles for Transport Application", 2018 INTERNATIONAL CONFERENCE ON APPLIED AND THEORETICAL ELECTRICITY (ICATE), IEEE, 4 October 2018 (2018-10-04), pages 1-8, XP033459491, DOI: 10.1109/ICATE.2018.8551485 [retrieved on 2018-11-28] * figures 2, 3, 5, 6 * | 1,6,7, 12-15 | TECHNICAL FIELDS SEARCHED (IPC) |

-/--

The present search report has been drawn up for all claims

| Place of search | Date of completion of the search | Examiner |
|---|---|---|
| Munich | 19 October 2022 | Agerbaek, Thomas |

EPO FORM 1503 03.82 (P04C01)

Europäisches
Patentamt
European
Patent Office
Office européen
des brevets

## EUROPEAN SEARCH REPORT

Application Number

EP 22 17 0550

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MURRAY DONAL B ET AL: "Cycle Testing of Supercapacitors for Long-Life Robust Applications", IEEE TRANSACTIONS ON POWER ELECTRONICS, INSTITUTE OF ELECTRICAL AND ELECTRONICS ENGINEERS, USA, vol. 30, no. 5, 1 May 2015 (2015-05-01), pages 2505-2516, XP011568925, ISSN: 0885-8993, DOI: 10.1109/TPEL.2014.2373368 [retrieved on 2014-12-23] * figures 1, 5-8 * | 1,6,7, 12-15 | |
| A | US 2014/062200 A1 (STUPKA RADEK [CZ]) 6 March 2014 (2014-03-06) * figures 1, 6-8 * | 2,3 | |

TECHNICAL FIELDS
SEARCHED      (IPC)

The present search report has been drawn up for all claims

| Place of search | Date of completion of the search | Examiner |
|---|---|---|
| Munich | 19 October 2022 | Agerbaek, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 22 17 0550

This annex lists the patent family members relating to the patent documents cited in the above-mentioned European search report.
The members are as contained in the European Patent Office EDP file on
The European Patent Office is in no way liable for these particulars which are merely given for the purpose of information.

19-10-2022

| Patent document cited in search report | | Publication date | Patent family member(s) | | Publication date |
|---|---|---|---|---|---|
| US 2009112493 | A1 | 30-04-2009 | CN | 101424716 A | 06-05-2009 |
| | | | EP | 2056116 A1 | 06-05-2009 |
| | | | ES | 2687079 T3 | 23-10-2018 |
| | | | FR | 2923020 A1 | 01-05-2009 |
| | | | US | 2009112493 A1 | 30-04-2009 |
| US 2009072839 | A1 | 19-03-2009 | KR | 20090029333 A | 23-03-2009 |
| | | | US | 2009072839 A1 | 19-03-2009 |
| WO 2019127184 | A1 | 04-07-2019 | NONE | | |
| WO 2019127185 | A1 | 04-07-2019 | NONE | | |
| US 2014062200 | A1 | 06-03-2014 | US | 2014062200 A1 | 06-03-2014 |
| | | | US | 2016276868 A1 | 22-09-2016 |

EPO FORM P0459

For more details about this annex : see Official Journal of the European Patent Office, No. 12/82